Europäisches Patentamt

(19) European Patent Office  (11) Publication number: **0 028 367**
Office européen des brevets  **B1**

(12) **EUROPEAN PATENT SPECIFICATION**

(45) Date of publication of patent specification: **14.08.85**  (51) Int. Cl.⁴: **G 03 F 9/00,** H 05 K 3/02

(21) Application number: **80106470.0**

(22) Date of filing: **23.10.80**

(54) **Registration process in a printing apparatus.**

(30) Priority: **01.11.79 US 90460**
**08.08.80 US 174263**

(43) Date of publication of application:
**13.05.81 Bulletin 81/19**

(45) Publication of the grant of the patent:
**14.08.85 Bulletin 85/33**

(84) Designated Contracting States:
**BE CH DE FR GB IT LI NL SE**

(56) References cited:
**FR-A-2 170 063**
**GB-A- 864 430**

**IRE CONVENTION RECORD, vol. 4, no. 6, June
1956, pages 115-119, Hollywood (USA); F.A.
SCHWERTZ et al: "Printed circuits via
xerography"**

(73) Proprietor: **E.I. DU PONT DE NEMOURS AND
COMPANY**
**1007 Market Street**
**Wilmington Delaware 19898 (US)**

(72) Inventor: **Jones, Charles Bradford**
**5447 Doral Drive**
**Fairway Falls Wilmington Delaware 19808 (US)**

(74) Representative: **Werner, Hans-Karsten, Dr. et al**
**Deichmannhaus am Hauptbahnhof**
**D-5000 Köln 1 (DE)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

This invention relates to registration of a printed image with a pattern on a receptor surface.

Various methods are known to pin register artwork with a receptor having a photosensitive surface so as to form an image in the photosensitive surface which is derived from the image in the artwork. The resultant image in the photosensitive surface can be used as a resist image to form a printed circuit as described, e.g., in U.S. Patent 3,469,982. In this process, the image in the photosensitive surface is formed *in situ*, i.e., in the photosensitive layer when it is present on the surface of the receptor.

The problem arises, however, that when the image is formed separately from the receptor and then transferred thereto, registration between this image and the pattern on the receptor is more difficult. This is especially true when the transfer is done kinetically, e.g., the image is rolled across the surface of the receptor such as by the use of a printing drum. The receptor, in the case of a printed circuit board, can have tooling and other holes drilled therein, and the transferred image has to be in precise register with these holes.

Furthermore, the prior art registration methods have relied upon manual and/or trial-and-error manipulations to obtain the desired registrations.

The present invention provides a process which solves the aforesaid registration problem. The process can be described as follows:

A process for transferring an image from a printing surface to a receptor surface by means of a printing apparatus comprising a movable printing surface support, a receptor loading station and a mechanism by which the receptor and printing surface are reproducibly moved into kinetic contact with each other, the loading station having a plurality of fixed target sensors thereon and the printing surface support having means for reproducibly positioning a printing surface thereon, in which for obtaining registration between the image on the printing surface and a corresponding pattern on the receptor surface the following steps are performed:

a. forming a plurality of registration targets on the receptor matching the target sensors of the loading station and having a fixed orientation and position with respect to the pattern on the receptor surface and bringing these targets into register with the sensors;

b. forming the image on the printing surface in a fixed orientation and position with respect to the printing surface support predetermined by the receptor positioning mechanism such that when the receptor is contacted with the printing surface the image is in register with the receptor pattern; and

c. transporting the receptor reproducibly into register by synchronizing the receptor transport with the movement of the printing surface support.

Unlike prior art registration methods, the process of the invention provides for "first article" registration, i.e., upon mounting the image upon the printing plate and preparing the receptor with the registration targets as described above, the first receptor as well as all subsequent receptors, is in precise registration without the necessity of trial and error adjustments.

FIG. 1 is a plan view of a printing plate having drum-mounting registration holes therein;

FIG. 2 is an end view of the printing plate of Fig. 1 mounted on the surface of a printing drum;

FIG. 3 is a plan view of artwork having holes thereon which represents one embodiment for achieving registration between the latent image to be derived from the artwork and the receptor for the developed latent image;

FIG. 4 is a perspective view of a coordinated feed arrangement for a printing apparatus;

FIG. 5 is an enlarged cross-sectional view of the registration pin adjustment mechanism of the platen of Fig. 4; and

FIG. 6 is an enlarged cross-sectional view of the printing apparatus of Fig. 4 showing details of the substrate gripping mechanism and related components.

For simplicity, details of the process of the present invention will be described for preferred materials wherein the receptor is a printed circuit board comprising a dielectric support and an electrically conductive layer adhered thereto, the printing medium is a magnetic printing plate and the latent magnetic image in the printing plate is developed by magnetic toner.

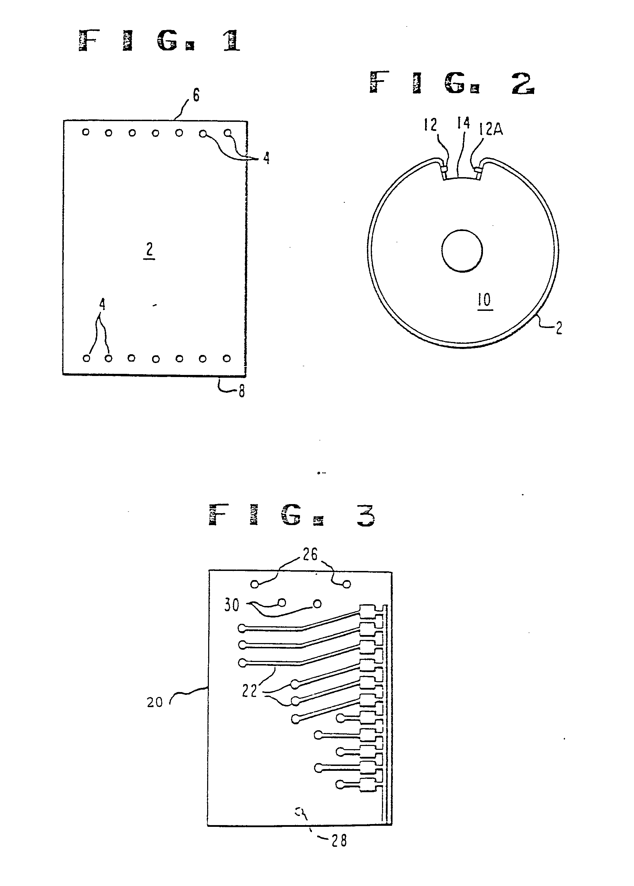

Fig. 1 shows a magnetic film 2 which can be a layer of permanent magnetic material such as $CrO_2$ particles dispersed in a binder matrix coated on a support film such as oriented polyethylene terephthalate. The film 2 has rows of a plurality of holes 4 adjacent the leading edge 6 and trailing edge 8 for mounting the film on a rotatable printing drum of a printing press.

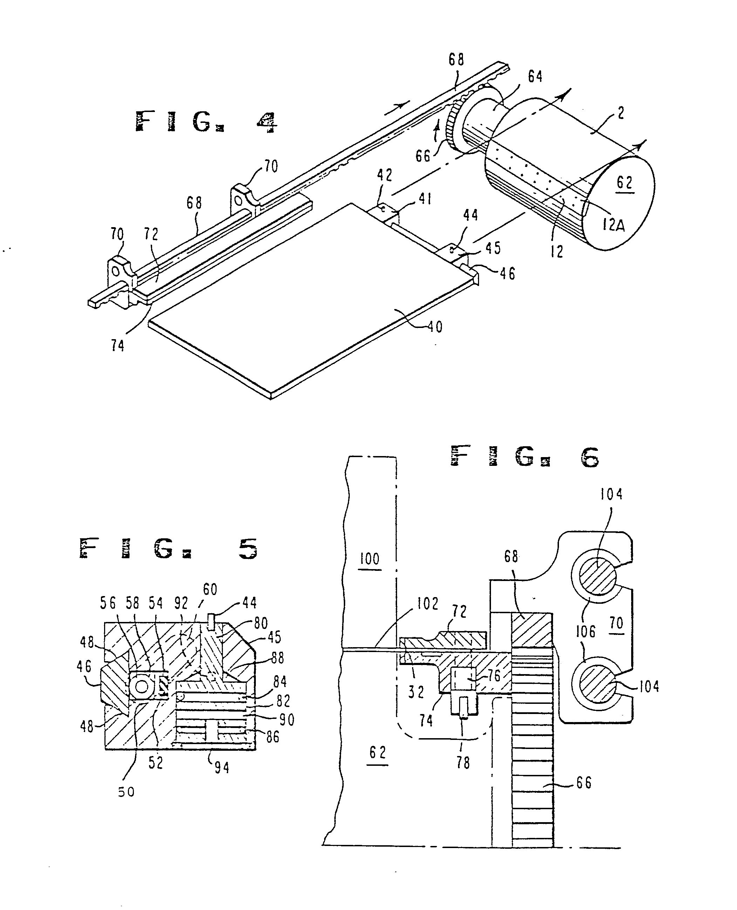

Fig. 2 shows magnetic film 2 mounted to the surface or rotatable printing drum 10 by a plurality of registration pins 12 and 12A extending from the sides of a longitudinal groove 14 in the periphery of the printing drum. The pins 12 and 12A are in rows, only the end pins of which are visible in Fig. 2. The spacing of the pins corresponds to the spacing between holes 4 in the film 2. These holes are conveniently punched in the magnetic film printing plate 2 by a punch which has been pre-set according to the spacing of pins 12 in each row. The rows of pins on the trailing edge 12A can be spring loaded so as to hold the film securely against the surface of the drum.

The pins 12 when inserted in holes 4 in the film thus provide a predetermined positioning of the magnetic film printing plate 2 on the drum 10. The next step is to properly locate the latent magnetic image in the magnetic film so that registration with the receptor is ultimately achieved. The latent image is located in the film by sensing the position of the plurality of holes 4 in the film 2 and forming the latent image in the film at a predetermined location in response to the sensing. The location of the holes and latent image thus have a fixed known spatial relationship to each other.

In one embodiment, the magnetic film 2 receives its latent image of a circuit pattern either before or after mounting on the printing drum 10 by using artwork having regions of different transparency to radiation forming the desired image in the artwork. Typically, the artwork will be a photographic negative in which the image is defined by opaque areas and transparent areas.

In order to register the image in the artwork with the film printing plate 2, i.e., in order to achieve the predetermined location of the latent image, a plurality of holes 26 (See Fig. 3) is formed in the artwork corresponding to the plurality of holes 4 in film 2. This can be done by using the same punch that punched holes 4 in film 2 to punch the same or fewer holes in the artwork, which thereby registers the artwork with the film. However, in accordance with the preferred embodiment, to achieve first article registration, it is necessary to punch into the artwork additional holes 30 in a fixed known spatial relationship to holes 26.

Fig. 3 shows the above-described preferred embodiment of the resultant artwork 20 having a plurality of holes 26 which correspond to a plurality of holes 4 of film 2 and a plurality of additional holes 30 at a predetermined location relative to holes 26. The holes 26 form a row which is adjacent the corresponding leading edge of the artwork. If desired, one or more holes, indicated in phantom lines as hole 28, can be punched in the trailing edge of the artwork to correspond with a hole 4 in film 2.

The latent image in artwork 20 can then be formed in film 2 by aligning the artwork with the film by registering holes 4 and 26, such as by the use of pins, and transferring the artwork image to the printing medium. This is accomplished by radiating the film through the artwork sufficiently to exceed the Curie temperature, which is 118°C for the preferred $CrO_2$ permanent magnetic material in the film, whereby the film loses its magnetism in the area exposed to the heating up provided by the radiation. The relatively unheated area of the film is still magnetic and thus forms in the film a latent magnetic image of a circuit pattern 22 (schematically represented) in the artwork. This image is developed by contacting the image with magnetic toner, which adheres to the latent magnetic image. Further description of preferred toner, which preferably comprises coalescible binder resin and magnetic particles, and a method of contacting the latent image with the toner is given in EP—A—4383.

In another embodiment, a computer is programmed with the image desired and the predetermined location of this image relative to a plurality of holes 4 in the film. This electronically stored image is then imparted to the film in conventional fashion such as by use of a scanning magnetic write head traversing the film 2 to form the latent image in the film.

The next step in the preferred embodiment is to sense the location of holes 30 in the artwork 20 relative to pattern 22 and form a plurality of registration holes in the receptor in response to this sensing. For example, holes 30 are translated by computer-controlled drilling to registration holes in the printed circuit board. Computer-controlled drilling is a conventional drilling operation, typically called numerically controlled (NC) drilling. An operator scans the artwork and wherever the image calls for a hole, the operator enters its coordinates in a tape, which can be a punched tape or a magnetic tape, which is the program for the drilling operation. At the time of this scan, the operator also registers the registration holes 30 in the tape. Holes 30 are then drilled in the same orientation relative to the pattern as the punched holes 30 have to image 22.

The holes drilled in the printed circuit board which correspond to holes 30 are registration holes 38 for positioning the printed circuit board in the feeding arrangement of the printing apparatus, to thereby achieve registration between the developed image from film 2 and the printed circuit board, particularly the holes drilled therein. All these holes are at a predetermined location relative to the latent image in the film so that registration of the printed circuit board and the developed latent image is eventually possible.

Fig. 4 shows a stationary loading platen 40 which can be used in the feeding arrangement of the printing apparatus as the receiver for a printed circuit board. Platen 40 has a registration pin 42 mounted on a stationary block 41 corresponding to the location of one of the holes 30 in the artwork and one of the holes in the printed circuit board and a registration pin 44 mounted on a block 45 which can be moved laterally to correspond to another of the holes 30 in the artwork and holes of the board. In this way, the location of pins 42 and 44 precisely corresponds to the registration holes drilled in the printed circuit board. Accordingly, pins 42 and 44 establish a fixed known spatial relationship for the printed circuit board located on the platen by the pins and the latent image in the magnetic film.

Block 45 is movable by virtue of a wedge-shaped (cross-section) bar 46 mounted to the downstream edge of platen 40, and block 45 having a corresponding wedge-shaped groove 48 for slidable mounting to the bar as best shown in Fig. 5. Block 45 also has groove 50 extending into the block from groove 48. Positioned along the base of groove 50 is a rubber strip 52 mounted in a grooved space 54. Cam 56 is rotatably positioned along groove 50. The cam has a flat face 58 and a lever 60 mounted to one end outside of block 45. In Fig. 5, the rubber strip 52 is compressed by the rotary position of the cam; the strip thereby biases the cam against bar 46 to lock block 45 in place. Movement of the lever 60, however, to place face 58 against the corresponding surface of spacer 54 relieves the compression thereby biasing the force of strip 52 to permit the block 45 to be relocated along bar 46.

Fig. 4 also shows the printing drum 62 of the printing apparatus, having magnetic film 2 secured thereto by rows of pins 12 and 12A extending through corresponding holes in the film. Drum 62 is rotatably mounted by conventional means (not shown) and has projection 64 extending from one end and a drive gear 66 mounted to this projection. Mating with the drive gear 66 and extending to the feed position of the apparatus is a rack gear 68.

Mounted to the rack gear adjacent the platen position as shown in Fig. 4 is a pair of spaced bearing carriers 70 and extending between these bearing carriers and mounted thereto are upper jaw 72 and lower jaw 74. Lower jaw 74 is fixedly mounted to the rack gear 68 and upper jaw 72 is movable upward and downward relative to the lower jaw 74 and is actuated by conventional means such as a double-acting air cylinder.

Fig. 5 shows means for retracting registration pins 42 and 44. Specifically, the pin 44 is mounted to the end of a piston 80 which is slidably mounted in a hole in block 45. This hole communicates with a cylindrical cavity 82 in the block. Positioned within the cavity is a pair of O-ring seals 84 and 86. These seals are spaced to define an upper air space 88 and lower air space 90 within the cavity. Upper and lower air holes 92 and 94, respectively, are provided in the cavity wall. To lower pin 44, pressurised air is admitted through air hole 92 to upper air space 88 and the lower air space 90 is simultaneously vented. To raise the pin, pressurized air is admitted through air hole 94 to air space 90 and upper air space 88 is vented through air hole 92. When rack gear 68 and drum 62 are rotated, pins 42 and 44 are retracted.

Jaws 72 and 74, actuated by a pneumatic, hydraulic or spring loaded mechanism (not shown) grip an edge of circuit board, usually called "robber's edge", by jaw 72 moving toward jaw 74.

Thus the circuit board is placed on platen 40, with the electrically conductive layer facing the platen, and the circuit board is properly positioned on the platen by pins 42 and 44 extending through holes 30 in the board. The pins are slightly smaller in diameter than the diameter of holes 30 to permit the pins to fit within the holes but nevertheless accurately to position the board on the platen. In this position, the robber's edge of the board extends between jaws 72 and 74. This position is then maintained by jaws 72 and 74 firmly gripping the board edge.

The rack gear 68 serves as the mechanical synchronizing linkage to translate the proper position of the board on the platen to registration of the board with the image in the magnetic film. Specifically, rotation of gear 66 in the direction shown in Fig. 4 causes the rack gear 68 to move toward the rotating drum 62, thus coordinating the feeding of the board with the rotation of the drum. That is, the surface speed of the gripped board is the same as the surface speed of the rotating drum.

Fig. 6 shows more detail of the printing apparatus than Fig. 4, especially, the presence of back-up roll 100 which forms a normally closed nip 102 with drum 62. Movement of rack gear 68 towards drum 62 causes board 32, gripped by jaws 72 and 74, to pass through nip 102, which forces the board with sufficient pressure against drum 62 to cause transfer of toner from the latent image in the film 2 on the drum to the conductive layer of the board.

Guidance of rack gear 68 and carriers 70 is provided by guide rails 104 on which ride sleeve bearings 106 contained within carriers 70.

An example of the present invention is as follows:

1) The desired circuit pattern is reproduced full-scale as a silver halide artwork, e.g., a silver halide image of the circuit pattern laid out on transparent Mylar (Registered Trade Mark) polyester film.

2. A magnetic film — the printing plate — is cut to fit the printing drum and punched with registration holes along the leading and trailing edges of the film to match a complementary set of two rows of pins in a groove in the print drum. Eleven 0.32 cm (0.125") diameter pins are used on both the leading and trailing edge of the film to distribute the load.

3) Artwork from step (1) is punched with a special registration punch. At least two of the holes punched are identical in diameter and center-to-center spacing to holes punched in the printing plate in step (2). These holes will be called "plate registration holes". In addition, two 0.32 cm (0.125") diameter "board registration holes" are punched in the artwork.

4) A circuit board drilling machine is programmed to drill circuit holes and board registration holes using the punched artwork of step (3) as a guide to locating the holes in the board.

5) The punched artwork is pin-registered (e.g., with Carlson 0.32 cm (0.125") diameter pins) to the printing plate by mating the plate registration holes, and this package is exposed to light which erases the magnetic attraction of the printing plate where it is struck by light. The latent magnetic image thus formed in the printing plate is located on the printing plate in an orientation that has been determined by the special artwork punch.

6) After the latent image has been toned the printing plate is mounted to the printing drum, using the plate registration holes punched in step (2).

The toned latent magnetic image is thus located on the printing drum in an orientation determined by the artwork punch.

7) The boards drilled in step (4) are registered on the board registration pins (42, 44) in the printer. This locates the board relative to the print drum in an orientation determined by the artwork punch. Thus, the artwork punch has tied the mechanical arrangements in the printer to the artwork, the printing plate and the circuit board as well.

8) The board is transported through the print zone, bringing the drilled board in contact with the printing plate by using the mechanism of Fig. 4.

While the embodiment of the invention described above utilizes conventional matching holes and pins as registration targets and sensors respectively, it will be appreciated by those skilled in the art that panel edge configuration and geometric shapes, such as notches and matching wedges can be used as well. Furthermore, it is contemplated that electronic means may also be used to carry out the target and sensor functions and their synchronization instead of mechanical means.

## Claims

1. A process for transferring an image from a printing surface (2) to a receptor surface by means of a printing apparatus comprising a movable printing surface support (10), a receptor loading station (40, 72, 74, 70) and a mechanism (66, 68) by which the receptor and printing surface are reproducibly moved into kinetic contact with each other, the loading station having a plurality of fixed target sensors (42, 44) thereon and the printing surface support having means (12, 12A) reproducibly positioning a printing surface thereon, characterized in that it includes for obtaining registration between the image on the printing surface and a corresponding pattern on the receptor surface the steps of:

a. forming a plurality of registration targets on the receptor matching the target sensors of the loading station and having a fixed orientation and position with respect to the pattern on the receptor surface and bringing these targets into register with the sensors;

b. Forming the image on the printing surface in a fixed orientation and position with respect to the printing surface support predetermined by the receptor positioning mechanism such that when the receptor is contacted with the printing surface the image is in register with the receptor pattern; and

c. transporting the receptor reproducibly in register by synchronizing the receptor transport with the movement of the printing surface support.

2. The process of claim 1 in which the registration targets are holes or notches and the target sensors are pins (42, 44) or wedges respectively.

3. The process of claim 2 in which the printing surface is a printing plate removable from said support having a plurality of positioning holes (4) corresponding to a plurality of mounting pins (12, 12A) on the printing surface support.

4. The process of claim 3 in which the image on the printing plate is formed from artwork (20) which is registered to the printing plate by means of holes (4) in the printing plate.

5. The process of claim 4 in which additional holes (30) are formed in the artwork corresponding to the holes formed in the receptor.

6. The process of claim 4 in which the position of the pattern and the targets on the receptor are derived from the image and from prepunched holes on the artwork.

7. The process of claim 1 wherein the receptor is a circuit board comprising a dielectric support and a layer of electrically conductive material thereon.

8. The process of claim 1 wherein the latent image is formed by scanning using electronically stored image information.

9. The process of claim 1 in which the printing surface is a magnetic printing plate having a latent image which has been developed with magnetic toner thereon and the plate has a plurality of holes (4) thereon for mounting the plate to the printing surface (10).

10. The process of claim 9 in which the printing surface support is the periphery of a rotatable drum (10) and the receptor is fed into contact with the drum during rotation thereof, to transfer the developed image to the receptor.

## Revendications

1. Procédé pour transférer une image d'une surface d'impression (2) sur une surface réceptrice au moyen d'un appareil d'impression comprenant un support mobile (10) de surface d'impression, un poste de chargement de récepteur (40, 72, 74, 70) et un mécanisme (66, 68) au moyen duquel le récepteur et la surface d'impression sont déplacés de façon reproductible en contact cinétique l'un avec l'autre, le post de chargement comportant une pluralité de détecteurs de cibles fixes (42, 44) et le support de la surface d'impression comportant des moyens (12, 12A) positionnant sur lui de façon reproductible une surface d'impression, caractérisé en ce qu'il comprend pour obtenir l'alignement entre l'image sur la surface d'impression et une motif correspondant sur la surface réceptrice les phases consistant à:

a) former sur le récepteur une pluralité de cibles d'alignement correspondant aux détecteurs de cibles du poste de chargement et ayant une orientation et une position fixes par rapport au motif sur la surface réceptrice et à amener ces cibles en alignement avec les détecteurs;

b) former l'image sur la surface d'impression avec une orientation et une position fixées par rapport au support de surface d'impression prédéterminée par le mécanisme d'alignement du récepteur de telle sorte que lorsque le récepteur est en contact avec la surface d'impression l'image soit alignée avec le motif du récepteur;

c) transporter le récepteur en alignement de façon reproductible en synchronisant le transport du récepteur avec le déplacement du support de la surface d'impression.

2. Procédé suivant la revendication 1 dans lequel les cibles d'alignement sont des trous ou des encoches et les détecteurs de cibles sont des ergots (42, 44) ou des coins respectivement.

3. Procédé suivant la revendication 2 dans lequel la surface d'impression est une plaque d'impression amovible dudit support comportant une pluralité de trous (4) d'alignement correspondant à une pluralité d'ergots de fixation (12, 12A) sur le support de la surface d'impression.

4. Procédé suivant la revendication 3, dans lequel l'image sur la plaque d'impression est formée à partir d'un modèle (20) qui est aligné sur la plaque d'impression au moyen de trous (4) dans la plaque d'impression.

5. Procédé suivant la revendication 4 dans lequel des trous additionnels (30) sont formés dans le modèle de façon à correspondre aux trous dormés dans le récepteur.

6. Procédé suivant la revendication 4 dans lequel la position du motif et des cibles sur le récepteur sont dérivées de l'image et des trous préalablement poinçonnés sur le modèle.

7. Procédé suivant la revendication 1 dans lequel le récepteur est une plaquette à circuits comprenant un support diélectrique et une couche d'une matière électriquement conductrice.

8. Procédé suivant la revendication 1 dans lequel l'image latente est formée par analyse en utilisant une information d'image emmagasinée électroniquement.

9. Procédé suivant la revendication 1 dans lequel la surface d'impression est une plaque d'impression magnétique ayant une image latente qui a été développée avec un toner magnétique sur elle et la plaque comporte une pluralité de trous (4) pour fixer la plaque sur la surface d'impression (10).

10. Procédé suivant la revendication 9 dans lequel le support de la surface d'impression est la périphérie d'un tambour rotatif (10) et le récepteur est avancé en contact avec le tambour pendant la rotation de celui-ci pour transférer l'image développée au récepteur.

**Patentansprüche**

1. Verfahren zur Übertragung eines Bildes von einer druckenden Oberfläche (2) auf eine Empfänger-Oberfläche mittels einer Druckeinrichtung mit einem beweglichen Träger (10) für die druckende Oberfläche, einer Beschickungsstation (40, 72, 74, 70) für Empfänger und einem Mechanismus (66, 68) mittels dessen Empfänger und druckende Oberfläche reproduzierbar in kinetischem Kontakt miteinander bewegt werden, wobei die Beschickungsstation mehrere auf ihr befindliche Zielmarkensensoren (42, 44) aufweist und der Träger für die druckende Oberfläche Mittel (12, 12A) aufweist, mittels derer die druckende Oberfläche reproduzierbar darauf in Position gebracht werden kann, dadurch gekennzeichnet, daß es zur Erzielung einer Ausrichtung zwischen dem Bild auf der druckenden Oberfläche und einem entsprechenden Muster auf der Empfänger-Oberfläche die nachstehenden Schritte einschließt:

a. Ausbilden einer Mehrzahl von Zielmarken auf dem Empfänger in Entsprechung zu den Zielmarkensensoren der Beschickungstation und mit fester Orientierung und Lage in bezug auf das Muster auf der Empfänger-Oberfläche und Ausrichtung dieser Zielmarken auf die Sensoren;

b. Formen des Bildes auf der druckenden Oberfläche in festgelegter Orientierung und Lage in bezug auf den Träger für die druckende Oberfläche mittels des Ausrichtungsmechanismus für den Empfänger in solcher Weise, daß dann, wenn der Empfänger in Kontakt mit der druckenden Oberfläche gebracht wird, das Bild sich in Ausrichtung mit dem Muster des Empfängers befindet;

c. reproduzierbares Transportieren des Empfängers in Ausrichtung durch Synchronisieren des Empfänger-Transports mit der Bewegung des Trägers für die druckende Oberfläche.

2. Verfahren nach Anspruch 1, dadurch gekennzeichnet, daß die Ausrichtungs-Zielmarken Löcher oder Kerben und die Zielmarkensensoren Nadeln (42, 44) oder Keile sind.

3. Verfahren nach Anspruch 2, dadurch gekennzeichnet, daß die druckende Oberfläche eine von dem Träger lösbare Druckform ist, die eine Mehrzahl von Löchern (4) zur Festlegung ihrer Position aufweist, welche einer Mehrzahl von Befestigungsnadeln (12, 12A) auf dem Träger für die druckende Oberfläche entsprechen.

4. Verfahren nach Anspruch 3, dadurch gekennzeichnet, daß das Bild auf der Druckform von einer Druckvorlage (20) hergestellt wird, die mit der Druckform mit Hilfe von Löchern (4) in der Druckform ausgerichtet wird.

5. Verfahren nach Anspruch 4, dadurch gekennzeichnet, daß in der Druckvorlage zusätzliche Löcher (30) hergestellt werden, die den im Empfänger gebildeten Löchern entsprechen.

6. Verfahren nach Anspruch 4, dadurch gekennzeichnet, daß die Positionen des Musters und der Zielmarkierungen auf dem Empfänger von dem Bild und von vorgestanzten Löchern auf der Druckvorlage abgeleitet werden.

7. Verfahren nach Anspruch 1, dadurch gekennzeichnet, daß der Empfänger eine gedruckte Schaltung mit einem dielektrischen Träger und einer auf diesem befindlichen Schicht eines elektrisch leitfähigen Materials ist.

8. Verfahren nach Anspruch 1, dadurch gekennzeichnet, daß das latente Bild durch Abtasten unter Nutzung elektronisch gespeicherter Bildinformationen hergestellt wird.

9. Verfahren nach Anspruch 1, dadurch gekennzeichnet, daß die druckende Oberfläche eine magnetische Druckplatte mit einem latenten Bild ist, das mittels eines darauf befindlichen magnetischen Toners entwickelt ist, und die Platte eine Mehrzahl von Löchern (4) zur Befestigung der Platte auf dem Träger (10) für die druckende Oberfläche aufweist.

10. Verfahren nach Anspruch 9, dadurch gekennzeichnet, daß der Träger für die druckende Oberfläche die Mantelfläche einer drehbaren Trommel (10) ist und der Empfänger durch die Rotation der Trommel zugeführt und mit dieser in Kontakt gebracht wird, um das entwickelte Bild auf den Empfänger zu übertragen.

# F I G. 1

# F I G. 2

# F I G. 3

F I G. 4

F I G. 5

F I G. 6